# FASCICULE DE BREVET EUROPEEN

(11) **EP 3 707 490 B1**
(45) Date de publication et mention de la délivrance du brevet: **06.10.2021**
(21) Numéro de dépôt: 18808446.1
(22) Date de dépôt: 05.11.2018
(51) Int. Cl.: H05K 1/18, G01M 5/00, G01M 7/02, G01N 29/04, G01N 29/12, G01N 29/22, G01N 29/24, H05K 1/14, H05K 1/16, H05K 3/46

(54) **PIÈCE COMPOSITE À CIRCUIT ÉLECTRONIQUE D'INSTRUMENTATION INTÉGRÉ ET SON PROCÉDÉ DE FABRICATION**
KOMPOSIT-BAUTEIL MIT INTEGRIERTER MESSGERÄTEAUSRÜSTUNGSPLATINE UND VERFAHREN ZU DEREN HERSTELLUNG
COMPOSITE COMPONENT WITH INTEGRATED INSTRUMENTATION ELECTRONIC CIRCUIT AND METHOD FOR MANUFACTURING THE SAME

(30) Priorité: 06.11.2017 FR 1760375
(43) Date de publication de la demande: 16.09.2020
(73) Titulaire: Safran, 75015 Paris (FR); Commissariat à l'Energie Atomique et aux Energies Alternatives, 75015 Paris (FR)
(72) Inventeur: JANFAOUI, Sabri, 77550 Moissy-Cramayel (FR); HADJRIA, Rafik, 77550 Moissy-Cramayel (FR)
(74) Mandataire: Regimbeau
(86) Numéro de dépôt international: PCT/FR2018/052712
(87) Numéro de publication internationale: WO 2019/086815

(56) Documents cités:
- EP-A2- 1 257 156
- WO-A1-2009/056472
- WO-A1-2013/074261
- US-A1- 2012 280 768

## Description

L'invention concerne une pièce composite (monolithique ou sandwich) comportant une surface extérieure rigide, à laquelle est intégré un circuit électronique d'instrumentation, ainsi qu'un procédé de fabrication de la pièce.

Un domaine d'application de l'invention concerne les structures utilisées dans le domaine de l'aéronautique, comme par exemple des parties de nacelles d'aéronefs.

Le document WO 2013/074261A1 concerne un résonateur combiné à un circuit passif, ayant un conducteur en forme de spirale et une couche piézoélectrique.

Le document WO 2009/056472A1 concerne un transducteur piézoélectrique de contrôle non destructif d'une structure, ayant deux composants actifs piézoélectriques situés entre deux couches diélectriques au voisinage d'un trou de passage d'un élément de fixation.

Le document US 2012/0280768A1 concerne un dispositif à ondes élastiques comportant un substrat piézoélectrique et des électrodes d'inductance disposées côte-à-côte.

Le document EP 1 257 156 A2 décrit une feuille flexible de circuit imprimé d'un convertisseur de tension.

Afin de suivre l'évolution de l'état de santé des structures aéronautiques, on souhaite utiliser des systèmes de diagnostic de l'état de la structure, également appelés systèmes SHM (en anglais : Structural Health Monitoring), qui permettent de suivre l'état de santé d'une structure tout au long de sa durée de vie, et ce en détectant, localisant et caractérisant la présence d'un défaut ayant survenu à cause des sollicitations environnementales de fonctionnement (température, sollicitations mécaniques ou autres) ou bien à cause d'un impact émanant d'un corps étranger (débris, impact d'un oiseau ou autres).

Un système de diagnostic comporte un ensemble de transducteurs (capteurs de température, de contrainte, de déformation, ou autres), une électronique de pilotage, et une unité de traitement. L'unité de traitement est associée à une interface Homme-Machine permettant à un opérateur d'investiguer les défauts.

Le système de diagnostic peut être totalement ou partiellement embarqué sur la structure et cela dépend de plusieurs facteurs (température, poids, autonomie...) mais à minima les capteurs sont embarqués sur la structure à instrumenter.

Parmi les technologies capteur/transducteur les plus utilisées pour la détection des défauts sur les structures métalliques et les structures en matériau composite est l'utilisation des transducteurs piézo-électriques, par exemple de type PZT (Titano-Zirconate de Plomb). Ces derniers peuvent être utilisés en mode émission (génération d'une onde guidée qui se propage dans la structure), ou bien en mode réception (écoute de l'onde propagée). En excitant le transducteur par un signal électrique prédéfini, le transducteur transforme ce signal électrique en une onde guidée mécanique. Cette onde se propage dans la structure. En arrivant sur un défaut, cette onde est réfléchie et est détectée par un ou plusieurs autres transducteurs placés sur ou dans la structure. A la réception de l'onde réfléchie, le transducteur transforme l'onde en un signal électrique. Les signaux électriques récupérés par les différents transducteurs sont ensuite envoyés à l'unité de traitement afin de détecter la présence d'un défaut, de le localiser et de le caractériser.

Un système de diagnostic est bénéfique pour l'optimisation de la maintenance d'un équipement. Néanmoins, il engendre l'ajout d'une masse non négligeable au poids de la structure à instrumenter (poids des câbles électriques, des attaches câbles, des connectiques). Une autre difficulté consiste à intégrer les transducteurs dans la structure composite. Plusieurs problèmes sont identifiés tels que le passage des câbles électriques à travers les plis de carbone (création de sources de défaillance), la dimension des câbles et des gaines (création de surépaisseur dans la matière).

Une difficulté identifiée lors d'une intervention de maintenance consiste à dé-câbler le système de diagnostic pour réparer le défaut et à ensuite re-câbler le système de diagnostic après la réparation de ce dernier, afin de continuer à suivre l'état de santé de l'équipement. Cette contrainte entraine une augmentation du temps et du coût de la maintenance.

L'invention vise à obtenir une solution d'intégration des éléments à la pièce composite, permettant d'alléger le poids du câblage du système de diagnostic et d'intégrer les transducteurs à la pièce, tout en s'affranchissant des problématiques liées aux câblages des transducteurs à travers la structure.

A cet effet, un premier objet de l'invention est une pièce composite, comportant une surface extérieure rigide, à laquelle est intégré un circuit électronique d'instrumentation,
le circuit électronique d'instrumentation comportant :
   - au moins un transducteur piézoélectrique, connecté à une première bobine,
   - un circuit électronique de pilotage, connecté à une deuxième bobine située en vis-à-vis de la première bobine,
caractérisée en ce que
la première bobine est imprimée sur au moins une première couche isolante de l'électricité, imprimée directement sur la surface extérieure rigide,
la deuxième bobine est imprimée sur au moins une troisième couche isolante de l'électricité, recouvrant la première bobine et le transducteur piézoélectrique,
des première et deuxième pistes conductrices de l'électricité sont imprimées sur une cinquième couche isolante de l'électricité imprimée sur au moins une partie de la deuxième bobine pour être reliées à la deuxième bobine, le circuit électronique de pilotage étant fixé sur la surface extérieure rigide et étant relié par un premier moyen de connexion électrique aux première et deuxième pistes conductrices de l'électricité.

Grâce à l'invention, aussi bien la première bobine reliée au transducteur piézoélectrique que la deuxième bobine reliée au circuit électronique de pilotage sont intégrés par une même technique d'impression à la pièce composite, permettant ainsi de gagner en compacité, en miniaturisation, en légèreté et en coût de fabrication. En effet, particulièrement dans le domaine de l'aéronautique, il faut que le circuit d'instrumentation perturbe le moins possible le flux de fluide environnant la pièce composite.

Suivant un mode de réalisation de l'invention, au moins une jauge de contrainte, terminée par un troisième contact d'extrémité et par un quatrième contact d'extrémité, et des troisième et quatrième pistes conductrices de l'électricité, reliées respectivement au troisième contact d'extrémité et au quatrième contact d'extrémité, sont imprimées sur la troisième couche isolante de l'électricité,
la jauge de contrainte et les troisième et quatrième pistes conductrices de l'électricité étant à distance des première et deuxième pistes,
le circuit électronique de pilotage étant relié par un deuxième moyen de connexion électrique aux troisième et quatrième pistes conductrices de l'électricité.

Suivant un mode de réalisation de l'invention, au moins un capteur de température, terminé par un cinquième contact d'extrémité et par un sixième contact d'extrémité, et des cinquième et sixième pistes conductrices de l'électricité, reliées respectivement au cinquième contact d'extrémité et au sixième contact d'extrémité, sont imprimés sur la troisième couche isolante de l'électricité,
le capteur de température et les cinquième et sixième pistes conductrices de l'électricité étant à distance des première et deuxième pistes,
le circuit électronique de pilotage étant relié par un troisième moyen de connexion électrique aux cinquième et sixième pistes conductrices de l'électricité.

Suivant un mode de réalisation de l'invention, la première bobine comporte un premier conducteur électrique ayant au moins une première spire terminée par un premier plot d'extrémité et par un deuxième plot d'extrémité,
la première spire et les premier et deuxième plots d'extrémité étant imprimés en une deuxième couche conductrice de l'électricité sur la première couche isolante de l'électricité, se trouvant elle-même sur la surface extérieure rigide,
le transducteur piézoélectrique ayant au moins une première borne électrique et une deuxième borne électrique, qui sont situées dans un plan situé sur la deuxième couche, qui sont positionnées respectivement sur les premier et deuxième plots et qui sont fixées d'une manière conductrice de l'électricité respectivement aux premier et deuxième plots,
la deuxième bobine comportant un deuxième conducteur électrique ayant au moins une deuxième spire terminée par un premier contact d'extrémité et par un deuxième contact d'extrémité,
la deuxième spire et les premier et deuxième contacts d'extrémité étant imprimés dans une quatrième couche conductrice de l'électricité sur la troisième couche,
les premier et deuxième contacts d'extrémité étant reliés à respectivement les première et deuxième pistes conductrices de l'électricité, imprimées en une sixième couche conductrice de l'électricité, située sur la cinquième couche isolante de l'électricité, imprimée sur une partie de la quatrième couche.

Suivant un mode de réalisation de l'invention, la jauge de contrainte et les troisième et quatrième pistes conductrices de l'électricité sont imprimées dans la quatrième couche sur la troisième couche.

Suivant un mode de réalisation de l'invention, le capteur de température et les cinquième et sixième pistes conductrices de l'électricité sont imprimées dans la quatrième couche sur la troisième couche.

Suivant un mode de réalisation de l'invention, la au moins une première spire s'étend entre une extrémité intérieure et une extrémité extérieure,
le premier plot est relié à l'extrémité intérieure de la au moins une première spire,
le deuxième plot est relié à l'extrémité extérieure de la au moins une première spire par une septième piste conductrice de l'électricité, imprimées en une septième couche conductrice de l'électricité, située sur une huitième couche isolante de l'électricité, imprimée sur la deuxième couche,
les premier et deuxième plots sont entourés par la au moins une première spire.

Suivant un mode de réalisation de l'invention, le premier plot occupe une majeure partie de l'espace entouré par la au moins une première spire.

Suivant un mode de réalisation de l'invention, la troisième couche comporte une neuvième couche de passivation, isolante de l'électricité, recouvrant la première bobine et le transducteur piézoélectrique, et une dixième couche isolante de l'électricité, imprimée entre la neuvième couche et la quatrième couche.

Suivant un mode de réalisation de l'invention, les pistes et la quatrième couche sont recouvertes d'une onzième couche de passivation, isolante de l'électricité.

Suivant un mode de réalisation de l'invention, la surface extérieure rigide est en un matériau composite monolithique.

Suivant un mode de réalisation de l'invention, la surface extérieure rigide est en un matériau composite ayant une structure de type sandwich.

Suivant un mode de réalisation de l'invention, le moyen de connexion électrique est flexible.

Suivant un mode de réalisation de l'invention, la pièce composite constitue une partie d'une nacelle de turbomachine d'aéronef ou une aube de turbomachine d'aéronef.

Suivant un mode de réalisation de l'invention, la pièce composite comporte comme surface extérieure rigide une première surface extérieure rigide et une deuxième surface extérieure rigide, qui est éloignée de la première surface extérieure rigide, un circuit électronique d'instrumentation étant intégré à chacune des première et deuxième surfaces extérieures rigides.

Un deuxième objet de l'invention est un procédé de fabrication d'une pièce composite telle que décrite ci-dessus, caractérisé en ce que
au cours d'une première étape, on imprime la première couche isolante de l'électricité sur la surface extérieure rigide,
au cours d'une deuxième étape postérieure à la première étape, on imprime une deuxième couche conductrice de l'électricité sur la première couche, pour former la première bobine comportant un premier conducteur électrique ayant au moins une première spire terminée par un premier plot d'extrémité et par un deuxième plot d'extrémité,
au cours d'une troisième étape postérieure à la deuxième étape, on positionne le transducteur piézoélectrique ayant des première et deuxième bornes électriques situées dans un plan respectivement sur les premier et deuxième plots, et on fixe d'une manière conductrice de l'électricité les première et deuxième bornes électriques respectivement aux premier et deuxième plots,
au cours d'une quatrième étape postérieure à la troisième étape, on recouvre de la au moins une troisième couche isolante de l'électricité la première bobine et le transducteur piézoélectrique,
au cours d'une cinquième étape postérieure à la quatrième étape, on imprime une quatrième couche conductrice de l'électricité sur la troisième couche, pour former la deuxième bobine comportant un deuxième conducteur électrique ayant au moins une deuxième spire terminée par un premier contact d'extrémité et par un deuxième contact d'extrémité, la deuxième bobine étant située en vis-à-vis de la première bobine,
au cours d'une sixième étape postérieure à la cinquième étape, on imprime la cinquième couche isolante de l'électricité sur une partie de la quatrième couche et on imprime une sixième couche conductrice de l'électricité sur la cinquième couche, pour former les première et deuxième pistes conductrices de l'électricité et pour relier les premier et deuxième contacts d'extrémité à respectivement les première et deuxième pistes,
au cours d'une septième étape postérieure à la sixième étape, on fixe le circuit électronique de pilotage sur la surface extérieure rigide et on relie le circuit électronique de pilotage par le premier moyen de connexion électrique aux première et deuxième pistes conductrices de l'électricité.

L'invention sera mieux comprise à la lecture de la description qui va suivre, donnée uniquement à titre d'exemple non limitatif en référence aux dessins annexés, sur lesquels :
- la figure 1 représente schématiquement en vue éclatée une pièce composite suivant un mode de réalisation de l'invention,
- les figures 2, 3, 4 et 5 représentent schématiquement des parties de la pièce composite suivant la figure 1,
- la figure 6 représente schématiquement en vue éclatée une pièce composite suivant deux modes de réalisation de l'invention,
- la figure 7 représente un organigramme du procédé de fabrication de la pièce composite suivant un mode de réalisation de l'invention.

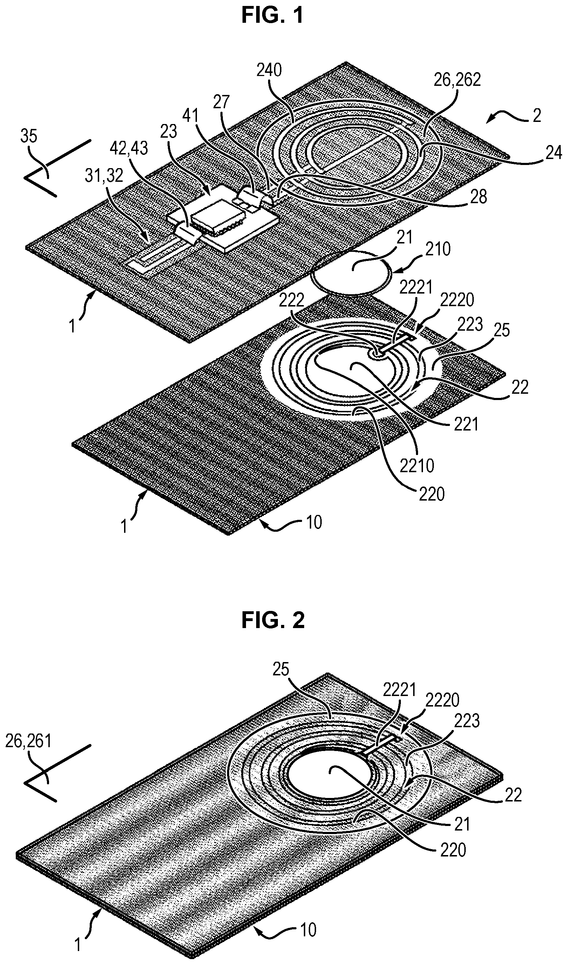

Aux figures 1 à 6, la pièce composite 1 comporte une surface extérieure rigide 10, à laquelle est intégré un circuit électronique 2 d'instrumentation.

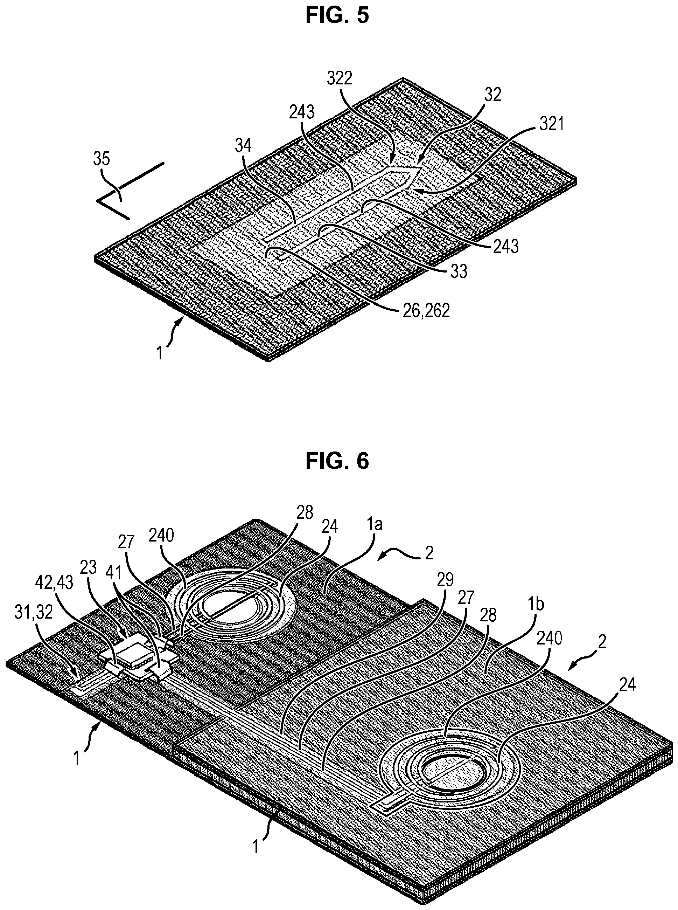

La pièce composite 1 est une pièce rigide. La pièce composite 1 peut être en un matériau composite monolithique (ainsi que représenté par la pièce composite la de la figure 6) ou en un matériau composite ayant une structure de type sandwich (ainsi que représenté par la pièce composite 1b de la figure 6). La pièce composite 1 peut être par exemple une pièce en carbone, réalisées par exemple en un ou plusieurs plis de carbone superposés.

Suivant un mode de réalisation, la pièce composite 1 comporte comme surface extérieure rigide 10 une première surface extérieure rigide à laquelle est intégré le circuit électronique 2 d'instrumentation et une deuxième surface extérieure rigide, qui est éloignée de la première surface extérieure rigide et à laquelle est intégré un autre circuit électronique 2 d'instrumentation analogue au circuit 2. La pièce composite 1 peut ainsi être une pièce de forme plate dont les deux côtés opposés l'un à l'autre (la première surface extérieure rigide et deuxième surface extérieure rigide) sont équipés chacun d'un circuit électronique 2 d'instrumentation. Par exemple, la pièce composite 1 peut notamment être une pièce aéronautique. En particulier, la pièce composite est une pièce embarquée sur l'aéronef. La pièce composite 1 peut notamment être par exemple une partie d'une turbomachine d'aéronef ou une partie d'une nacelle de turbomachine d'aéronef ou structure de type IFS (en anglais : internai fixed structure pour structure fixée de manière interne) d'un inverseur de poussée (nacelle), pouvant être équipée sur chacun de ses deux côtés opposés d'un circuit électronique 2 d'instrumentation. La pièce composite 1 peut également être une pièce tournante ou une partie d'une pièce tournante, comme par exemple une aube de turbomachine d'aéronef.

L'invention prévoit d'intégrer par impression le circuit électronique 2 d'instrumentation directement sur la surface extérieure rigide 10 de la pièce 1 à instrumenter. Ainsi, le circuit électronique 2 d'instrumentation est embarqué avec la pièce composite 1.

Le circuit électronique 2 d'instrumentation comporte un ou plusieurs transducteur(s) piézoélectrique(s) 21, par exemple en Titano-Zirconate de Plomb (appelé PZT), qui est (sont) intégré(s) à la surface extérieure rigide 10 de la pièce 1 à instrumenter. Dans le cas de plusieurs transducteurs piézoélectriques 21, ceux-ci sont espacés l'un de l'autre sur la surface extérieure rigide 10. Ce qui est décrit ci-dessous pour un transducteur piézoélectrique 21 s'applique à chaque transducteur piézoélectrique 21.

Le transducteur piézoélectrique 21 est connecté à une première bobine 22 (appelée également bobine secondaire 22), réalisée par impression sur une première couche 25 isolante de l'électricité, imprimée directement sur la surface extérieure rigide (10).

Le circuit électronique 2 d'instrumentation comporte en outre un circuit électronique 23 de pilotage, connecté à une deuxième bobine 24 (appelée également bobine primaire 24), qui est située à distance et en vis-à-vis de la première bobine 22 et qui est réalisée par impression sur une autre couche 26 isolante de l'électricité, recouvrant la première bobine 22 et le transducteur piézoélectrique 21 et imprimée sur celles-ci.

Des première et deuxième pistes 27, 28 conductrices de l'électricité sont imprimées sur une cinquième couche 29 isolante de l'électricité imprimée sur au moins une partie de la deuxième bobine 24 pour être reliées par impression à la deuxième bobine 24. Le circuit électronique 23 de pilotage est fixé sur la surface extérieure rigide 10 et étant relié par un premier moyen 41 de connexion électrique aux première et deuxième pistes 27, 28 conductrices de l'électricité. La piste 27 et/ou 28 comporte ainsi une partie s'étendant au-dessus de la deuxième bobine 24 et une autre partie s'étendant à l'extérieur de la deuxième bobine 24 jusqu'au premier moyen 41 de connexion électrique. Le premier moyen 41 de connexion électrique peut être flexible

Les bobines 24 et 22 sont agencées pour avoir un couplage électromagnétique entre elles, leur permettant de se transmettre des signaux sans contact. Le transducteur piézoélectrique 21 peut ainsi être piloté sans contact par le circuit électronique 23 de pilotage, via la bobine 24 et la bobine 22. Les bobines 22 et 24 sont réalisées par impression.

Le fonctionnement du circuit 2 est le suivant.

Dans un premier mode d'émission du circuit 2, le circuit électronique 23 de pilotage envoie le premier signal électrique de pilotage vers la bobine primaire 24. La bobine 24 transforme ce premier signal électrique en un champ électromagnétique. La bobine secondaire 22 placée dans ce champ transforme ce champ électromagnétique en un deuxième signal électrique d'excitation. Ce deuxième signal électrique d'excitation excite le transducteur 21 et permet d'envoyer une onde mécanique guidée dans le matériau de la surface extérieure rigide 10.

Dans un deuxième mode de réception du circuit 2, le transducteur 21 reçoit une onde émise par un autre transducteur 21 distant à travers le matériau de la surface extérieure rigide 10. Cette onde est transformée par le transducteur 21 en un troisième signal électrique. Le troisième signal électrique est transformé par la bobine secondaire 22 en un champ électromagnétique. Ce champ est transformé à nouveau par la bobine primaire 24 en un quatrième signal électrique. Ce quatrième signal électrique est ensuite récupéré et traité par le circuit électronique 23 de pilotage.

L'analyse du quatrième signal électrique à partir du premier signal électrique de pilotage permet de détecter un défaut de la surface extérieure rigide 10 de la pièce composite 1. Dans un mode de réalisation, le circuit électronique 23 de pilotage comporte des moyens de traitement du quatrième signal électrique pour détecter et/ou localiser et/ou identifier un défaut. Dans un autre mode de réalisation, le circuit électronique 23 de pilotage est connecté à un autre circuit de traitement du quatrième signal électrique pour détecter et/ou localiser et/ou identifier un défaut.

Dans un mode de réalisation, le circuit électronique 23 de pilotage comporte un moyen pour réaliser un autodiagnostic du transducteur 21, et ce sans contact, pour par exemple détecter une défaillance du transducteur 21 en mesurant par exemple son impédance électromécanique caractéristique. Cela permet de valider l'opérabilité ou non du transducteur 21 avant son utilisation pour la détection de défauts.

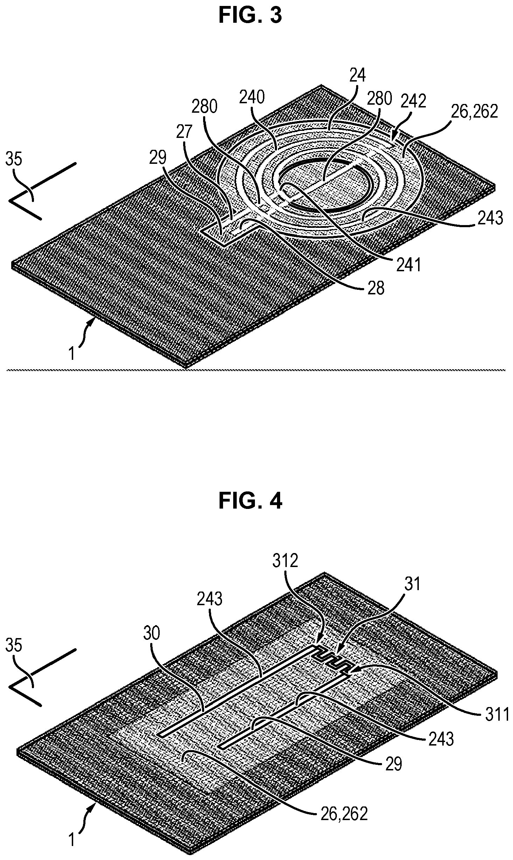

Suivant un mode de réalisation, ainsi que représenté aux figures 1 et 4, la pièce composite 1 peut comporter une ou plusieurs jauges 31 de contrainte, permettant de mesurer une déformation de la surface extérieure rigide 10. La au moins une jauge 31 de contrainte peut également être imprimée sur la cinquième couche 29 isolante. Suivant un mode de réalisation, la au moins une jauge 31 de contrainte est terminée par un troisième contact 311 d'extrémité et par un quatrième contact 312 d'extrémité. Des troisième et quatrième pistes 29, 30 conductrices de l'électricité sont imprimées sur la troisième couche 26 isolante pour être reliées par impression respectivement au troisième contact 311 d'extrémité et au quatrième contact 312 d'extrémité. La jauge 31 de contrainte et les troisième et quatrième pistes 29, 30 sont à distance des première et deuxième pistes 27, 28. Le circuit électronique 23 de pilotage est relié par un deuxième moyen 42 de connexion électrique aux troisième et quatrième pistes 29, 30 conductrices de l'électricité. Le deuxième moyen 42 de connexion électrique peut être flexible.

Suivant un mode de réalisation, ainsi que représenté aux figures 1 et 5, la pièce composite 1 peut comporter un ou plusieurs capteur(s) 32 de température, permettant de mesurer une température de la surface extérieure rigide 10. Le capteur 32 de température peut comporter par exemple un thermocouple. Le au moins un capteur 32 de température peut également être imprimé sur la cinquième couche 29 isolante. Suivant un mode de réalisation, le au moins un capteur 32 de température est terminé par un cinquième contact 321 d'extrémité et par un sixième contact 322 d'extrémité. Des cinquième et sixième pistes 33, 34 conductrices de l'électricité sont imprimées sur la troisième couche 26 isolante de l'électricité, pour être reliées par impression respectivement au cinquième contact 321 d'extrémité et au sixième contact 322 d'extrémité. Le capteur 32 de température et les cinquième et sixième pistes 33, 34 conductrices de l'électricité sont à distance des première et deuxième pistes 27, 28 et des troisième et quatrième pistes 29, 30. Le circuit électronique 23 de pilotage est relié par un troisième moyen 43 de connexion électrique aux cinquième et sixième pistes 33, 34 conductrices de l'électricité. Le troisième moyen 43 de connexion électrique peut être flexible.

On décrit ci-dessous un mode de réalisation du circuit 2 par impression, ainsi que représenté aux figures 1 à 5. Le circuit 2 comporte, sur la surface extérieure rigide 10, successivement :
- la première couche 25 isolante de l'électricité,
- la deuxième couche 223 conductrice de l'électricité, pour former la bobine 22,
- la troisième couche 26 isolante de l'électricité,
- la quatrième couche 243 conductrice de l'électricité, pour former la bobine 24, et les pistes 29, 30 et/ou 33, 34 lorsqu'elles sont présentes,
- la cinquième couche 29 isolante de l'électricité,
- la sixième couche 280 conductrice de l'électricité, pour former les pistes 27, 28.

Ces couches imprimées ont les localisations suivantes pour intégrer le transducteur 21, les bobines 22 et 24 et les pistes 27 et 28 servant à l'accès du circuit électronique 23 de pilotage à la bobine 24.

Suivant un mode de réalisation, ainsi que représenté aux figures 1 et 2, la première bobine 22 comporte un premier conducteur électrique ayant au moins une première spire 220 terminée par un premier plot 221 d'extrémité et par un deuxième plot 222 d'extrémité.

Suivant un mode de réalisation, ainsi que représenté aux figures 1 et 2, la première spire 220 et les premier et deuxième plots 221, 222 d'extrémité sont imprimés en la deuxième couche 223 conductrice de l'électricité sur la première couche 25 isolante de l'électricité, se trouvant elle-même sur la surface extérieure rigide 10.

Suivant un mode de réalisation, ainsi que représenté aux figures 1 et 2, le transducteur piézoélectrique 21 a au moins une première borne électrique et une deuxième borne électrique, qui sont situées dans un plan 210 situé sur la deuxième couche 223. La première borne électrique et la deuxième borne électrique sont positionnées respectivement sur le premier plot 221 et sur le deuxième plot 222 et sont fixées d'une manière conductrice de l'électricité respectivement au premier plot 221 et au deuxième plot 222.

Suivant un mode de réalisation, ainsi que représenté aux figures 1 et 3, la deuxième bobine 24 comporte un deuxième conducteur électrique ayant au moins une deuxième spire 240 terminée par un premier contact 241 d'extrémité et par un deuxième contact 242 d'extrémité. La deuxième spire 240 et les premier et deuxième contacts 241, 242 d'extrémité sont imprimés dans la quatrième couche 243 conductrice de l'électricité sur la troisième couche 26. Les premier et deuxième contacts 241, 242 d'extrémité sont reliés à respectivement les première et deuxième pistes 27, 28 conductrices de l'électricité. Les première et deuxième pistes 27, 28 conductrices de l'électricité sont imprimées en une sixième couche 280 conductrice de l'électricité, située sur la cinquième couche 29 isolante de l'électricité, laquelle est imprimée sur une partie de la quatrième couche 243.

Suivant un mode de réalisation, ainsi que représenté aux figures 3 et 4, la jauge 31 de contrainte et les troisième et quatrième pistes 29, 30 conductrices de l'électricité sont imprimées dans la quatrième couche 243 sur la troisième couche 26.

Suivant un mode de réalisation, ainsi que représenté aux figures 3 et 5, le capteur 32 de température et les cinquième et sixième pistes 33, 34 conductrices de l'électricité sont imprimées dans la quatrième couche 243 sur la troisième couche 26.

On décrit ci-dessous un mode de réalisation de la bobine 22, ainsi que représenté aux figures 1 et 2.

Suivant un mode de réalisation, la au moins une première spire s'étend entre une extrémité intérieure 2210 et une extrémité extérieure 2220. Le premier plot 221 est relié à l'extrémité intérieure 2210, le deuxième plot 222 est relié à l'extrémité extérieure 2220 par une septième piste 2221 conductrice de l'électricité. La septième piste 2221 conductrice de l'électricité est imprimée en une septième couche conductrice de l'électricité, située sur une huitième couche isolante de l'électricité, laquelle est imprimée sur la deuxième couche 223. Les premier et deuxième plots 221, 222 sont entourés par la au moins une première spire.

Suivant un mode de réalisation, le premier plot 221 occupe une majeure partie de l'espace entouré par la au moins une première spire.

Suivant un mode de réalisation, ainsi que représenté aux figures 2 à 5, la troisième couche 26 comporte une neuvième couche 261 de passivation, isolante de l'électricité, recouvrant la première bobine 22 et le transducteur piézoélectrique 21, et une dixième couche 262 isolante de l'électricité, imprimée entre la neuvième couche 261 et la quatrième couche 243.

Suivant un mode de réalisation, ainsi que représenté aux figures 1, 3, 4 et 5, les pistes 27, 28, la quatrième couche 243 et les pistes 29, 30 et/ou 33, 34 lorsqu'elles sont présentes, sont recouvertes d'une onzième couche 35 de passivation, isolante de l'électricité.

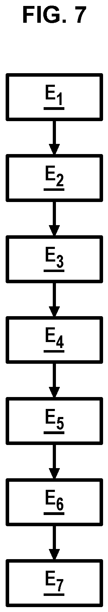

On décrit ci-dessous, en référence à la figure 7, un procédé de fabrication de la pièce composite 1 décrite ci-dessus. Les étapes d'impression peuvent effectuées par une technique d'impression de type aérosol ou jet d'encre par exemple.

Au cours d'une première étape E₁, on imprime la première couche 25 isolante de l'électricité sur la surface extérieure rigide 10. La première couche 25 isolante est imprimée à l'endroit défini pour accueillir la bobine 22 et le transducteur piézoélectrique 21 sur la surface extérieure rigide 10.

Au cours d'une deuxième étape E₂ postérieure à la première étape E₁, on imprime la deuxième couche 223 conductrice de l'électricité sur la première couche 25, pour former la première bobine 22 comportant un premier conducteur électrique ayant la au moins une première spire 220 terminée par un premier plot 221 d'extrémité et par un deuxième plot 222 d'extrémité. On imprime également l'empreinte du transducteur piézoélectrique 21, laissant la place pour insérer celui-ci dans cette empreinte.

Au cours d'une troisième étape E₃ postérieure à la deuxième étape E₂, on positionne le transducteur piézoélectrique 21, en positionnant les première et deuxième bornes électriques situées dans le plan 210 respectivement sur les premier et deuxième plots 221, 222. On positionne ainsi le transducteur piézoélectrique 21 dans son empreinte, le transducteur piézoélectrique 21 étant un composant préfabriqué. On fixe d'une manière conductrice de l'électricité les première et deuxième bornes électriques respectivement aux premier et deuxième plots 221, 222, par exemple par une colle conductrice de l'électricité déposée entre d'une part les première et deuxième bornes électriques et d'autre part les premier et deuxième plots 221, 222.

Au cours d'une quatrième étape E₄ postérieure à la troisième étape E₃, on recouvre de la au moins une troisième couche 26 isolante de l'électricité la première bobine 22 et le transducteur piézoélectrique 21. La troisième couche 26 isolante est imprimée à l'endroit défini pour accueillir la bobine 24, les pistes 27 et 28, ainsi que les pistes 29, 30 et la au moins une jauge 31 de contrainte et/ou que les pistes 33, 34 et le au moins un capteur 32 de température, lorsqu'ils sont présents.

Au cours d'une cinquième étape E₅ postérieure à la quatrième étape E₄, on imprime une quatrième couche 243 conductrice de l'électricité sur la troisième couche 26, pour former, au-dessus de la première bobine 22, la deuxième bobine 24 comportant le deuxième conducteur électrique ayant au moins une deuxième spire 240 terminée par le premier contact 241 d'extrémité et par le deuxième contact 242 d'extrémité, les pistes 27 et 28, ainsi que les pistes 29, 30 et la au moins une jauge 31 de contrainte et/ou que les pistes 33, 34 et le au moins un capteur 32 de température, lorsqu'ils sont présents.

Au cours d'une sixième étape E₆ postérieure à la cinquième étape E₅, on imprime la cinquième couche 29 isolante de l'électricité sur une partie de la quatrième couche 243. On imprime une sixième couche 280 conductrice de l'électricité sur la cinquième couche 29, pour former les première et deuxième pistes 27, 28 conductrices de l'électricité et pour relier les premier et deuxième contacts 241, 242 d'extrémité à respectivement les première et deuxième pistes 27, 28.

Au cours d'une septième étape E₇ postérieure à la sixième étape E₆, on fixe le circuit électronique 23 de pilotage sur la surface extérieure rigide 10. On relie le circuit électronique 23 de pilotage par le premier moyen 41 de connexion électrique aux première et deuxième pistes 27, 28 conductrices de l'électricité et aux pistes 29, 30 par le moyen 42 et/ou aux pistes 33, 34 par le moyen 43, lorsqu'elles sont présentes.

Bien entendu, les modes de réalisation, caractéristiques et exemples ci-dessus peuvent être combinés l'un avec l'autre ou être sélectionnés indépendamment l'un de l'autre.

## Revendications

1. Pièce composite (1), comportant une surface extérieure rigide (10), à laquelle est intégré un circuit électronique (2) d'instrumentation,
le circuit électronique (2) d'instrumentation comportant :
- au moins un transducteur piézoélectrique (21), connecté à une première bobine (22),
- un circuit électronique (23) de pilotage, connecté à une deuxième bobine (24) située en vis-à-vis de la première bobine (22),
**caractérisée en ce que**
la première bobine (22) est imprimée sur au moins une première couche (25) isolante de l'électricité, imprimée directement sur la surface extérieure rigide (10),
la deuxième bobine (24) est imprimée sur au moins une troisième couche (26) isolante de l'électricité, recouvrant la première bobine (22) et le transducteur piézoélectrique (21),
des première et deuxième pistes (27, 28) conductrices de l'électricité sont imprimées sur une cinquième couche (29) isolante de l'électricité imprimée sur au moins une partie de la deuxième bobine (24) pour être reliées à la deuxième bobine (24), le circuit électronique (23) de pilotage étant fixé sur la surface extérieure rigide (10) et étant relié par un premier moyen (41) de connexion électrique aux première et deuxième pistes (27, 28) conductrices de l'électricité.

2. Pièce composite (1) suivant la revendication 1, **caractérisée en ce qu'**au moins une jauge (31) de contrainte, terminée par un troisième contact (311) d'extrémité et par un quatrième contact (312) d'extrémité, et des troisième et quatrième pistes (29, 30) conductrices de l'électricité, reliées respectivement au troisième contact (311) d'extrémité et au quatrième contact (312) d'extrémité, sont imprimées sur la troisième couche (26) isolante de l'électricité,
la jauge (31) de contrainte et les troisième et quatrième pistes (29, 30) conductrices de l'électricité étant à distance des première et deuxième pistes (27, 28),
le circuit électronique (23) de pilotage étant relié par un deuxième moyen (42) de connexion électrique aux troisième et quatrième pistes (29, 30) conductrices de l'électricité.

3. Pièce composite (1) suivant la revendication 1 ou 2, **caractérisée en ce qu'**au moins un capteur (32) de température, terminé par un cinquième contact (321) d'extrémité et par un sixième contact (322) d'extrémité, et des cinquième et sixième pistes (33, 34) conductrices de l'électricité, reliées respectivement au cinquième contact (321) d'extrémité et au sixième contact (322) d'extrémité, sont imprimés sur la troisième couche (26) isolante de l'électricité,
le capteur (32) de température et les cinquième et sixième pistes (33, 34) conductrices de l'électricité étant à distance des première et deuxième pistes (27, 28),
le circuit électronique (23) de pilotage étant relié par un troisième moyen (43) de connexion électrique aux cinquième et sixième pistes (33, 34) conductrices de l'électricité.

4. Pièce composite (1) suivant l'une quelconque des revendications précédentes, **caractérisée en ce que** la première bobine (22) comporte un premier conducteur électrique ayant au moins une première spire (220) terminée par un premier plot (221) d'extrémité et par un deuxième plot (222) d'extrémité,
la première spire (220) et les premier et deuxième plots (221, 222) d'extrémité étant imprimés en une deuxième couche (223) conductrice de l'électricité sur la première couche (25) isolante de l'électricité, se trouvant elle-même sur la surface extérieure rigide (10),
le transducteur piézoélectrique (21) ayant au moins une première borne électrique et une deuxième borne électrique, qui sont situées dans un plan (210) situé sur la deuxième couche (223), qui sont positionnées respectivement sur les premier et deuxième plots (221, 222) et qui sont fixées d'une manière conductrice de l'électricité respectivement aux premier et deuxième plots (221, 222),
la deuxième bobine (24) comportant un deuxième conducteur électrique ayant au moins une deuxième spire (240) terminée par un premier contact (241) d'extrémité et par un deuxième contact (242) d'extrémité,
la deuxième spire (240) et les premier et deuxième contacts (241, 242) d'extrémité étant imprimés dans une quatrième couche (243) conductrice de l'électricité sur la troisième couche (26),
les premier et deuxième contacts (241, 242) d'extrémité étant reliés à respectivement les première et deuxième pistes (27, 28) conductrices de l'électricité, imprimées en une sixième couche (280) conductrice de l'électricité, située sur la cinquième couche (29) isolante de l'électricité, imprimée sur une partie de la quatrième couche (243).

5. Pièce composite (1) suivant les revendications 2 et 4 prises ensemble, **caractérisée en ce que** la jauge (31) de contrainte et les troisième et quatrième pistes (29, 30) conductrices de l'électricité sont imprimées dans la quatrième couche (243) sur la troisième couche (26).

6. Pièce composite (1) suivant les revendications 3 et 4 prises ensemble, **caractérisée en ce que** le capteur (32) de température et les cinquième et sixième pistes (33, 34) conductrices de l'électricité sont imprimées dans la quatrième couche (243) sur la troisième couche (26).

7. Pièce composite (1) suivant l'une quelconque des revendications 4 à 6, **caractérisée en ce que**
la au moins une première spire s'étend entre une extrémité intérieure (2210) et une extrémité extérieure (2220),
le premier plot (221) est relié à l'extrémité intérieure (2210) de la au moins une première spire,
le deuxième plot (222) est relié à l'extrémité extérieure (2220) de la au moins une première spire par une septième piste (2221) conductrice de l'électricité, imprimées en une septième couche conductrice de l'électricité, située sur une huitième couche isolante de l'électricité, imprimée sur la deuxième couche (223),
les premier et deuxième plots (221, 222) sont entourés par la au moins une première spire.

8. Pièce composite (1) suivant la revendication précédente, **caractérisée en ce que** le premier plot (221) occupe une majeure partie de l'espace entouré par la au moins une première spire.

9. Pièce composite (1) suivant l'une quelconque des revendications 4 à 8, **caractérisée en ce que** la troisième couche (26) comporte une neuvième couche (261) de passivation, isolante de l'électricité, recouvrant la première bobine (22) et le transducteur piézoélectrique (21), et une dixième couche (262) isolante de l'électricité, imprimée entre la neuvième couche (261) et la quatrième couche (243).

10. Pièce composite (1) suivant l'une quelconque des revendications 4 à 9, **caractérisée en ce que** les pistes (27, 28) et la quatrième couche (243) sont recouvertes d'une onzième couche (35) de passivation, isolante de l'électricité.

11. Pièce composite (1) suivant l'une quelconque des revendications précédentes, **caractérisée en ce que** la surface extérieure rigide (10) est en un matériau composite monolithique.

12. Pièce composite (1) suivant l'une quelconque des revendications 1 à 11, **caractérisée en ce que** la surface extérieure rigide (10) est en un matériau composite ayant une structure de type sandwich.

13. Pièce composite (1) suivant l'une quelconque des revendications 1 à 11, **caractérisée en ce que** le moyen (41, 42, 43) de connexion électrique est flexible.

14. Pièce composite (1) suivant l'une quelconque des revendications précédentes, **caractérisée en ce qu'**elle constitue une partie d'une nacelle de turbomachine d'aéronef ou une aube de turbomachine d'aéronef.

15. Pièce composite (1) suivant l'une quelconque des revendications précédentes, **caractérisée en ce que** la pièce composite (1) comporte comme surface extérieure rigide (10) une première surface extérieure rigide et une deuxième surface extérieure rigide, qui est éloignée de la première surface extérieure rigide, un circuit électronique (2) d'instrumentation étant intégré à chacune des première et deuxième surfaces extérieures rigides.

16. Procédé de fabrication d'une pièce composite (1) suivant l'une quelconque des revendications précédentes, **caractérisé en ce que**
au cours d'une première étape (E₁), on imprime la première couche (25) isolante de l'électricité sur la surface extérieure rigide (10),
au cours d'une deuxième étape (E₂) postérieure à la première étape (E₁), on imprime une deuxième couche (223) conductrice de l'électricité sur la première couche (25), pour former la première bobine (22) comportant un premier conducteur électrique ayant au moins une première spire (220) terminée par un premier plot (221) d'extrémité et par un deuxième plot (222) d'extrémité,
au cours d'une troisième étape (E₃) postérieure à la deuxième étape (E₂), on positionne le transducteur piézoélectrique (21) ayant des première et deuxième bornes électriques situées dans un plan (210) respectivement sur les premier et deuxième plots (221, 222), et on fixe d'une manière conductrice de l'électricité les première et deuxième bornes électriques respectivement aux premier et deuxième plots (221, 222),
au cours d'une quatrième étape (E₄) postérieure à la troisième étape (E₃), on recouvre de la au moins une troisième couche (26) isolante de l'électricité la première bobine (22) et le transducteur piézoélectrique (21),
au cours d'une cinquième étape (E₅) postérieure à la quatrième étape (E₄), on imprime une quatrième couche (243) conductrice de l'électricité sur la troisième couche (26), pour former la deuxième bobine (24) comportant un deuxième conducteur électrique ayant au moins une deuxième spire (240) terminée par un premier contact (241) d'extrémité et par un deuxième contact (242) d'extrémité, la deuxième bobine (24) étant située en vis-à-vis de la première bobine (22),
au cours d'une sixième étape (E₆) postérieure à la cinquième étape (E₅), on imprime la cinquième couche (29) isolante de l'électricité sur une partie de la quatrième couche (243) et on imprime une sixième couche (280) conductrice de l'électricité sur la cinquième couche (29), pour former les première et deuxième pistes (27, 28) conductrices de l'électricité et pour relier les premier et deuxième contacts (241, 242) d'extrémité à respectivement les première et deuxième pistes (27, 28),
au cours d'une septième étape (E₇) postérieure à la sixième étape (E₆), on fixe le circuit électronique (23) de pilotage sur la surface extérieure rigide (10) et on relie le circuit électronique (23) de pilotage par le premier moyen (41) de connexion électrique aux première et deuxième pistes (27, 28) conductrices de l'électricité.

## Patentansprüche

1. Komposit-Bauteil (1), aufweisend eine starre Außenfläche (10), in die eine elektronische Instrumentierungsschaltung (2) integriert ist,
wobei die elektronische Instrumentierungsschaltung (2) aufweist:
- mindestens einen piezoelektronischen Wandler (21), der mit einer ersten Spule (22) verbunden ist,
- eine elektronische Steuerschaltung (23), die mit einer zweiten Spule (24) verbunden ist, die sich gegenüber der ersten Spule (22) befindet,
**dadurch gekennzeichnet, dass**
die erste Spule (22) auf mindestens eine erste elektrisch isolierende Schicht (25) gedruckt ist, die direkt auf die starre Außenfläche (10) gedruckt ist,
die zweite Spule (24) auf mindestens eine dritte elektrisch isolierende Schicht (26) gedruckt ist, die die erste Spule (22) und den piezoelektronischen Wandler (21) bedeckt,
eine erste und zweite elektrische Leiterbahn (27, 28) auf eine fünfte elektrisch isolierende Schicht (29) gedruckt sind, die auf mindestens einen Teil der zweiten Spule (24) gedruckt ist, um mit der zweiten Spule (24) verbunden zu sein, wobei die elektronische Steuerschaltung (23) auf der starren Außenfläche (10) befestigt ist und durch ein erstes elektrisches Verbindungsmittel (41) mit der ersten und zweiten elektrischen Leiterbahn (27, 28) verbunden ist.

2. Komposit-Bauteil (1) nach Anspruch 1, **dadurch gekennzeichnet, dass** mindestens ein Dehnungsmessstreifen (31), der in einem dritten Endkontakt (311) und in einem vierten Endkontakt (312) endet, und eine dritte und vierte elektrische Leiterbahn (29, 30), die jeweils mit dem dritten Endkontakt (311) und mit dem vierten Endkontakt (312) verbunden sind, auf die dritte elektrisch isolierende Schicht (26) gedruckt sind,
wobei der Dehnungsmessstreifen (31) und die dritte und vierte elektrische Leiterbahn (29, 30) von der ersten und zweiten Bahn (27, 28) beabstandet sind,
wobei die elektronische Steuerschaltung (23) durch ein zweites elektrisches Verbindungsmittel (42) mit der dritten und vierten elektrischen Leiterbahn (29, 30) verbunden ist.

3. Komposit-Bauteil (1) nach Anspruch 1 oder 2, **dadurch gekennzeichnet, dass** mindestens ein Temperatursensor (32), der in einem fünften Endkontakt (321) und in einem sechsten Endkontakt (322) endet, und eine fünfte und sechste elektrische Leiterbahn (33, 34), die jeweils mit dem fünften Endkontakt (321) und mit dem sechsten Endkontakt (322) verbunden sind, auf die dritte elektrisch isolierende Schicht (26) gedruckt sind,
wobei der Temperatursensor (32) und die fünfte und sechste elektrische Leiterbahn (33, 34) von der ersten und zweiten Bahn (27, 28) beabstandet sind,
wobei die elektronische Steuerschaltung (23) durch ein drittes elektrisches Verbindungsmittel (43) mit der fünften und sechsten elektrischen Leiterbahn (33, 34) verbunden ist.

4. Komposit-Bauteil (1) nach einem beliebigen der vorangehenden Ansprüche, **dadurch gekennzeichnet, dass** die erste Spule (22) einen ersten elektrischen Leiter mit mindestens einer ersten Windung (220) aufweist, die in einer ersten Endkontaktstelle (221) und in einer zweiten Endkontaktstelle (222) endet,
wobei die erste Windung (220) und die erste und zweite Endkontaktstelle (221, 222) in einer zweiten elektrisch leitenden Schicht (223) auf die erste elektrisch isolierende Schicht (25) gedruckt sind, die sich selbst auf der starren Außenfläche (10) befindet,
wobei der piezoelektronische Wandler (21) mindestens eine erste elektrische Klemme und eine zweite elektrische Klemme hat, die sich in einer Ebene (210) befinden, die sich auf der zweiten Schicht (223) befindet, die jeweils auf der ersten und zweiten Kontaktstelle (221, 222) positioniert sind und die stromleitend jeweils auf der ersten und zweiten Kontaktstelle (221, 222) befestigt sind,
wobei die zweite Spule (24) einen zweiten elektrischen Leiter mit mindestens einer zweiten Windung (240) aufweist, die in einem ersten Endkontakt (241) und in einem zweiten Endkontakt (242) endet,
wobei die zweite Windung (240) und der erste und zweite Endkontakt (241, 242) in einer vierten elektrisch leitenden Schicht (243) auf die dritte Schicht (26) gedruckt sind,
wobei der erste und zweite Endkontakt (241, 242) jeweils mit der ersten und zweiten elektrischen Leiterbahn (27, 28) verbunden sind, die in einer sechsten elektrisch leitenden Schicht (280) gedruckt sind, die sich auf der fünften elektrisch isolierenden Schicht (29) befindet, die auf einem Teil der vierten Schicht (243) gedruckt ist.

5. Komposit-Bauteil (1) nach den gemeinsam herangezogenen Ansprüchen 2 und 4, **dadurch gekennzeichnet, dass** der Dehnungsmessstreifen (31) und die dritte und vierte elektrische Leiterbahn (29, 30) in der vierten Schicht (243) auf die dritte Schicht (26) gedruckt sind.

6. Komposit-Bauteil (1) nach den gemeinsam herangezogenen Ansprüchen 3 und 4, **dadurch gekennzeichnet, dass** der Temperatursensor (32) und die fünfte und sechste elektrische Leiterbahn (33, 34) in der vierten Schicht (243) auf die dritte Schicht (26) gedruckt sind.

7. Komposit-Bauteil (1) nach einem beliebigen der Ansprüche 4 bis 6, **dadurch gekennzeichnet, dass**
sich die mindestens eine erste Windung zwischen einem inneren Ende (2210) und einem äußeren Ende (2220) erstreckt,
die erste Kontaktstelle (221) mit dem inneren Ende (2210) der mindestens einen ersten Windung verbunden ist,
die zweite Kontaktstelle (222) mit dem äußeren Ende (2220) der mindestens einen ersten Windung durch eine siebte elektrische Leiterbahn (2221) verbunden ist, die in einer siebten elektrisch leitenden Schicht gedruckt sind, die sich auf einer achten elektrisch isolierenden Schicht befindet, die auf die zweite Schicht (223) gedruckt ist,
die erste und zweite Kontaktstelle (221, 222) von der mindestens einen ersten Windung umgeben sind.

8. Komposit-Bauteil (1) nach vorangehendem Anspruch, **dadurch gekennzeichnet, dass** die erste Kontaktstelle (221) einen Großteil des Raums belegt, der von der mindestens einen ersten Windung umgeben ist.

9. Komposit-Bauteil (1) nach einem beliebigen der Ansprüche 4 bis 8, **dadurch gekennzeichnet, dass** die dritte Schicht (26) eine neunte elektrisch isolierende Passivierungsschicht (261) aufweist, die die erste Spule (22) und den piezoelektronischen Wandler (21) bedeckt, und eine zehnte elektrisch isolierende Schicht (262), die zwischen der neunten Schicht (261) und der vierten Schicht (243) gedruckt ist.

10. Komposit-Bauteil (1) nach einem beliebigen der Ansprüche 4 bis 9, **dadurch gekennzeichnet, dass** die Bahnen (27, 28) und die vierte Schicht (243) mit einer elften elektrisch isolierenden Passivierungsschicht (35) bedeckt sind.

11. Komposit-Bauteil (1) nach einem beliebigen der vorangehenden Ansprüche, **dadurch gekennzeichnet, dass** die starre Außenfläche (10) aus einem monolithischen Komposit-Material ist.

12. Komposit-Bauteil (1) nach einem beliebigen der Ansprüche 1 bis 11, **dadurch gekennzeichnet, dass** die starre Außenfläche (10) aus einem Komposit-Material mit einer Sandwichstruktur ist.

13. Komposit-Bauteil (1) nach einem beliebigen der Ansprüche 1 bis 11, **dadurch gekennzeichnet, dass** das elektrische Verbindungsmittel (41, 42, 43) flexibel ist.

14. Komposit-Bauteil (1) nach einem beliebigen der vorangehenden Ansprüche, **dadurch gekennzeichnet, dass** es einen Teil einer Gondel einer Turbomaschine eines Fluggeräts oder einer Schaufel einer Turbomaschine eines Fluggeräts bildet.

15. Komposit-Bauteil (1) nach einem beliebigen der vorangehenden Ansprüche, **dadurch gekennzeichnet, dass** das Komposit-Bauteil (1) als starre Außenfläche (10) eine erste starre Außenfläche und eine zweite starre Außenfläche, die von der ersten starren Außenfläche entfernt ist, aufweist, wobei eine elektronische Instrumentierungsschaltung (2) in jede von der ersten und zweiten starren Außenfläche integriert ist.

16. Verfahren zur Herstellung eines Komposit-Bauteils (1) nach einem beliebigen der vorangehenden Ansprüche, **dadurch gekennzeichnet, dass**
bei einem ersten Schritt (E₁) die erste elektrisch isolierende Schicht (25) auf die starre Außenfläche (10) gedruckt wird,
bei einem zweiten Schritt (E₂) nach dem ersten Schritt (E₁) eine zweite elektrisch leitende Schicht (223) auf die erste Schicht (25) gedruckt wird, um die erste Spule (22) zu bilden, die einen ersten elektrischen Leiter mit mindestens einer ersten Windung (220) aufweist, die in einer ersten Endkontaktstelle (221) und in einer zweiten Endkontaktstelle (222) endet,
bei einem dritten Schritt (E₃) nach dem zweiten Schritt (E₂) der piezoelektronische Wandler (21) mit einer ersten und zweiten elektrischen Klemme, die sich in einer Ebene (210) befinden, jeweils auf der ersten und zweiten Kontaktstelle (221, 222) positioniert wird, und die erste und zweite elektrische Klemme jeweils an der ersten und zweiten Kontaktstelle (221, 222) elektrisch leitend befestigt werden,
bei einem vierten Schritt (E₄) nach dem dritten Schritt (E₃) die erste Spule (22) und der piezoelektronische Wandler (21) mit der mindestens einen dritten elektrisch isolierenden Schicht (26) bedeckt werden,
bei einem fünften Schritt (E₅) nach dem vierten Schritt (E₄) eine vierte elektrisch leitende Schicht (243) auf die dritte Schicht (26) gedruckt wird, um die zweite Spule (24) zu bilden, die einen zweiten elektrischen Leiter mit mindestens einer zweiten Windung (240) aufweist, die in einem ersten Endkontakt (241) und in einem zweiten Endkontakt (242) endet, wobei sich die zweite Spule (24) gegenüber der ersten Spule (22) befindet,
bei einem sechsten Schritt (E₆) nach dem fünften Schritt (E₅) die fünfte elektrisch isolierende Schicht (29) auf einen Teil der vierten Schicht (243) gedruckt wird und eine sechste elektrisch leitende Schicht (280) auf die fünfte Schicht (29) gedruckt wird, um die erste und zweite elektrische Leiterbahn (27, 28) zu bilden und um den ersten und zweiten Endkontakt (241, 242) mit jeweils der ersten und zweiten Bahn (27, 28) zu verbinden,
bei einem siebten Schritt (E₇) nach dem sechsten Schritt (E₆) die elektronische Steuerschaltung (23) auf der starren Außenfläche (10) befestigt wird und die elektronische Steuerschaltung (23) durch das erste elektrische Verbindungsmittel (41) mit der ersten und zweiten elektrischen Leiterbahn (27, 28) verbunden wird.

## Claims

1. A composite part (1), comprising a rigid outer surface (10), to which is integrated an electronic instrumentation circuit (2),
the electronic instrumentation circuit (2) comprising:
- at least one piezoelectric transducer (21), connected to a first coil (22),
- an electronic control circuit (23), connected to a second coil (24) positioned facing the first coil (22),
**characterized in that**
the first coil (22) is printed on at least one first electrically insulating layer (25) printed directly on the rigid outer surface (10),
the second coil (24) is printed on at least one third electrically insulating layer (26) covering the first coil (22) and the piezoelectric transducer (21),
first and second electrically conducting tracks (27, 28) are printed on a fifth electrically insulating layer (29) printed on at least one portion of the second coil (24) to be connected to the second coil (24), the electronic control circuit (23) being attached to the rigid outer surface (10) and being connected by a first electrical connection means (41) to the first and second electrically conducting tracks (27, 28).

2. The composite part (1) according to claim 1, **characterized in that** at least one strain gauge (31), terminated by a third end contact (311) and by a fourth end contact (312), and third and fourth electrically conducting tracks (29, 30), connected respectively to the third end contact (311) and to the fourth end contact (312), are printed on the third electrically insulating layer (26),
the strain gauge (31) and the third and fourth electrically conducting tracks (29, 30) being at a distance from the first and second tracks (27, 28),
the electronic control circuit (23) being connected by a second electrical connection means (42) to the third and fourth electrically conducting tracks (29, 30).

3. The composite part (1) according to claim 1 or 2, **characterized in that** at least one temperature sensor (32), terminated by a fifth end contact (321) and by a sixth end contact (322), and fifth and sixth electrically conducting tracks (33, 34), connected respectively to the fifth end contact (321) and to the sixth end contact (322), are printed on the third electrically insulating layer (26),
the temperature sensor (32) and the fifth and sixth electrically conducting tracks (33, 34) being at a distance from the first and second tracks (27, 28),
the electronic control circuit (23) being connected by a third electrical connection means (43) to the fifth and sixth electrically conducting tracks (33, 34).

4. The composite part (1) according to any one of the preceding claims, **characterized in that** the first coil (22) comprises a first electrical conductor having at least one first turn (220) terminated by a first end stud (221) and by a second end stud (222),
the first turn (220) and the first and second end studs (221, 222) being printed in a second electrically conducting layer (223) on the first electrically insulating layer (25), itself located on the rigid outer surface (10),
the piezoelectric transducer (21) having at least one first electrical terminal and one second electrical terminal, which are positioned in a plane (210) positioned on the second layer (223), which are positioned respectively on the first and second studs (221, 222) and which are attached in an electrically conducting manner respectively to the first and second studs (221, 222),
the second coil (24) comprising a second electrical conductor having at least one second turn (240) terminated by a first end contact (241) and by a second end contact (242),
the second turn (240) and the first and second end contacts (241, 242) being printed in a fourth electrically conducting layer (243) on the third layer (26),
the first and second end contacts (241, 242) being connected respectively to the first and second electrically conducting tracks (27, 28) printed in a sixth electrically conducting layer (280), positioned on the fifth electrically insulating layer (29), printed on a portion of the fourth layer (243).

5. The composite part (1) according to claims 2 and 4 taken together, **characterized in that** the strain gauge (31) and the third and fourth electrically conducting tracks (29, 30) are printed in the fourth layer (243) on the third layer (26).

6. The composite part (1) according to claims 3 and 4 taken together, **characterized in that** the temperature sensor (32) and the fifth and sixth electrically conducting tracks (33, 34) are printed in the fourth layer (243) on the third layer (26).

7. The composite part (1) according to any one of claims 4 to 6, **characterized in that**
the at least one first turn extends between an inner end (2210) and an outer end (2220),
the first stud (221) is connected to the inner end (2210) of the at least one first turn,
the second stud (222) is connected to the outer end (2220) of the at least one first turn by a seventh electrically conducting track (2221) printed in a seventh electrically conducting layer positioned on an eighth electrically insulating layer printed on the second layer (223),
the first and second studs (221, 222) are surrounded by the at least one first turn.

8. The composite part (1) according to the preceding claim, **characterized in that** the first stud (221) occupies a major portion of the space surrounded by the at least one first turn.

9. The composite part (1) according to any one of claims 4 to 8, **characterized in that** the third layer (26) comprises a ninth electrically insulating passivation layer (261), covering the first coil (22) and the piezoelectric transducer (21), and a tenth electrically insulating layer (262), printed between the ninth layer (261) and the fourth layer (243).

10. The composite part (1) according to any one of claims 4 to 9, **characterized in that** the tracks (27, 28) and the fourth layer (243) are covered with an eleventh electrically insulating passivation layer (35).

11. The composite part (1) according to any one of the preceding claims, **characterized in that** the rigid outer surface (10) is of a monolithic composite material.

12. The composite part (1) according to any one of claims 1 to 11, **characterized in that** the rigid outer surface (10) is of a composite material having a sandwich type structure.

13. The composite part (1) according to any one of claims 1 to 11, **characterized in that** the electrical connection means (41, 42, 43) is flexible.

14. The composite part (1) according to any one of the preceding claims, **characterized in that** it constitutes a portion of an aircraft turbomachine nacelle or an aircraft turbomachine blade.

15. The composite part (1) according to any one of the preceding claims, **characterized in that** the composite part (1) comprises, as a rigid outer surface (10), a first rigid outer surface and a second rigid outer surface, which is remote from the first rigid outer surface, an electronic instrumentation circuit (2) being integrated with each of the first and second rigid outer surfaces.

16. A manufacturing method for manufacturing a composite part (1) according to any one of the preceding claims, **characterized in that**
during a first step (E₁), the first electrically insulating layer (25) is printed on the rigid outer surface (10),
during a second step (E₂) subsequent to the first step (E₁), a second electrically conducting layer (223) is printed on the first layer (25), to form the first coil (22) comprising a first electrical conductor having at least one first turn (220) terminated by a first end stud (221) and by a second end stud (222),
during a third step (E₃) subsequent to the second step (E₂), the piezoelectric transducer (21) having first and second electrical terminals positioned in a plane (210) is positioned respectively on the first and second studs (221, 222), and the first and second electrical terminals are attached in an electrically conducting manner respectively to the first and second studs (221, 222),
during a fourth step (E₄) subsequent to the third step (E₃), the first coil (22) and the piezoelectric transducer (21) are covered with the at least one third electrically insulating layer (26),
during a fifth step (E₅) subsequent to the fourth step (E₄), a fourth electrically conducting layer (243) is printed on the third layer (26), to form the second coil (24) comprising a second electrical conductor having at least one second turn (240) terminated by a first end contact (241) and by a second end contact (242), the second coil (24) being positioned facing the first coil (22),
during a sixth step (E₆) subsequent to the fifth step (E₅), the fifth electrically insulating layer (29) is printed on a portion of the fourth layer (243) and a sixth electrically conducting layer (280) is printed on the fifth layer (29), to form the first and second electrically conducting tracks (27, 28) and to connect the first and second end contacts (241, 242) respectively to the first and second tracks (27, 28),
during a seventh step (E₇) subsequent to the sixth step (E₆), the electronic control circuit (23) is attached to the rigid outer surface (10) and the electronic control circuit (23) is connected by the first electrical connection means (41) to the first and second electrically conducting tracks (27, 28).
